# EUROPÄISCHE PATENTSCHRIFT

(11) **EP 3 068 042 B1**
(45) Veröffentlichungstag und Bekanntmachung des Hinweises auf die Patenterteilung: **04.08.2021**
(21) Anmeldenummer: 16159889.1
(22) Anmeldetag: 11.03.2016
(51) Int. Cl.: H01L 31/044, H02S 20/22, H02S 20/23, H02S 99/00

(54) **VERFAHREN ZUR SCHAFFUNG VON FLEXIBEL EINSETZBAREN PHOTOVOLTAIKMODULEN**
METHOD FOR CREATING FLEXIBLY USABLE PHOTOVOLTAIC MODULES
PROCEDE DE CREATION DE MODULES PHOTOVOLTAÏQUES UTILISABLE DE MANIÈRE FLEXIBLE

(30) Priorität: 11.03.2015 CH 3332015
(43) Veröffentlichungstag der Anmeldung: 14.09.2016
(73) Patentinhaber: Schmid, Rene, 8049 Zürich (CH)
(72) Erfinder: Schmid, Rene, 8049 Zürich (CH)
(74) Vertreter: Keller Schneider Patent- und Markenanwälte AG (Zürich)

(56) Entgegenhaltungen:
- WO-A1-01/94719
- WO-A2-2008/051997
- US-A1- 2011 308 563
- US-A1- 2014 305 493
- THOMAS STARK ET AL: "Konstruktive Varianten beim Modulaufbau", PHOTOVOLTAIK ARCHITEKTONISCHE GEBAEUDEINTEGRATION, XX, XX, 1. Juli 2000 (2000-07-01), Seiten 10-15,18, XP002171489,

## Beschreibung

### Technisches Gebiet

Die vorliegende Erfindung beschreibt ein Verfahren zur Schaffung von Photovoltaikanlagen mit mehreren Photovoltaikmodulen in gewünschter Gestalt, wobei das Photovoltaikmodul eine verkapselte Laminatstruktur, umfassend eine Frontschutzscheibe, ein Matrixmaterial von welchem eine frontseitige Elektrodenlage und eine photovoltaische Lage umschlossen ist, sowie eine rückseitige Elektrodenlage und eine Rückwand aufweist, mit elektrischen Anschlüssen an einer Seite des Photovoltaikmoduls, wobei die photovoltaische Lage durch mehrere Solarzellen in mehreren Strängen angeordnet gebildet ist, wobei die Solarzellen jedes Stranges durch mindestens eine Bypass-Diode abgesichert sind, und ein starres Photovoltaikmodul mit einer verkapselten Laminatstruktur, umfassend eine Frontschutzscheibe, ein Matrixmaterial von welchem eine frontseitige Elektrodenlage und eine photovoltaische Lage umschlossen ist, sowie eine rückseitige Elektrodenlage und eine Rückwand, wobei das Photovoltaikmodul an einer Seite elektrische Anschlüsse aufweist, wobei mehrere Solarzellen in mehreren Strängen angeordnet gebildet sind, wobei die Solarzellen jedes Stranges durch mindestens eine Bypass-Diode abgesichert sind, wodurch das Photovoltaikmodul bei teilweisem Zuschnitt automatisch aktiv bleibt.

### Stand der Technik

Seitdem die Preise kommerziell erhältlicher Photovoltaikmodule oder Solarmodule stark gesunken sind, hat ein regelrechter Boom eingesetzt, was die Bedeckung der Gebäudehüllflächen mit Photovoltaikmodulen angeht. Neben Dachflächen werden vermehrt auch Fassadenflächen mit Photovoltaikmodulen ausgestattet, um möglichst viel Strom aus Sonnenlicht zu generieren, wobei in der Regel eine Mehrzahl von Photovoltaikmodulen eine Photovoltaikanlage bildet.

Der Photovoltaikanlageninstallateur ist es gewohnt mit Photovoltaikmodulen fester Grösse zu arbeiten, da solche Photovoltaikmodule in einheitlichen Grössen massenhaft hergestellt werden. Ein Auftraggeber bestellt möglichst eine hohe Stückzahl um möglichst alle Bereiche der Gebäudehüllfläche, die zur Stromproduktion beitragen kann, abdecken lassen zu können. Es werden Halterungen auf Dach- und/oder Fassadenflächen fixiert und die Photovoltaikmodule daran samt Verkabelung montiert. Kommerziell erhältliche Halterungen sind auf die vorkonfektionierten Photovoltaikmodule angepasst. Bei der Montage muss vor allem auf die elektrische Verkabelung geachtet werden, sodass diese keinen Schaden nimmt.

Die hier interessierenden starren vorkonvektionierten Photovoltaikmodule weisen fixe Modulgrössen auf und umfassen jeweils eine Mehrzahl von siliziumbasierten Solarzellen. Die Lage der Solarzellen ist meist in eine transparente Kunststoffschicht als Matrixlage eingebettet und auf der zur Sonne gewandten Seite mit einer Frontschutzscheibe und auf der Rückseite der Solarzellenlage mit einer Rückwand, eine Stützkonstruktion bildend verbunden. Derartige einfache Photovoltaikmodule weisen eine Laminatstruktur auf, welche dauerhaft verkapselt ist, sodass keine Feuchtigkeit oder Schmutz zwischen die Lagen des Photovoltaikmoduls dringen kann. Ein solches Photovoltaikmodul wird auch als Glas-Folien Modul bezeichnet und ist relativ kostengünstig. Während die Frontschutzscheibe als eine einfache Glasplatte wählbar ist, welche die empfindliche Solarzellenlage als photoaktive Lage vor Schäden schützt, ist dem Fachmann bekannt, dass die Laminatstruktur bzw. die Verkapselung nicht verletzt sein darf, da bisher immer galt, dass die Lebensdauer eines Photovoltaikmoduls ansonsten signifikant geringer wird.

Um die vorhandene Gebäudehüllfläche möglichst vollständig zu bedecken, werden heute Photovoltaikmodule in Standardgrössen bestellt und verwendet, wobei kaum Spezialgrössen vorgesehen sind. Der Fachmann kennt die Anfälligkeit der Laminatstruktur und der elektrischen Verkabelung, weshalb er keine Manipulation konfektionierter Photovoltaikmodule vornimmt und entsprechend die Gebäudehüllfläche teilweise unbedeckt belässt.

Aus XP002171489 (Thomas Stark et al. "Konstruktive Varianten beim Modulaufbau", Photovoltaik Architektonische Gebaeudeintegration, 1. Juli 2000, Seiten 10-15, 18) gehen unterschiedlich geformte Photovoltaikmodule mit unterschiedlichen verkapselten Laminatstrukturen hervor, welche mit mindestens einer Bypass-Diode ausgestattet sind. Durch die darin beschriebenen PV-Module können in unterschiedlicher Gestaltung unterschiedlich geformte Dach- und Fassadenflächen bedeckt werden, wobei die bedeckten Flächen auch aus teilweise inaktiven PV-Modulen bestehen.

### Darstellung der Erfindung

Die vorliegende Erfindung hat sich zur Aufgabe gestellt ein Verfahren zu schaffen, mittels welchem eine optimale photovoltaische Nutzung der Dach- bzw. Fassadenfläche eines Gebäudes erreichbar ist.

Zur Lösung der Aufgabe werden Photovoltaikmodule auf einer Baustelle kurz vor der Montage auf gewünschte Grössen flexibel zugeschnitten, was entgegen der bisherigen Meinung des Fachmanns doch möglich ist. Die notwendigen Arbeitsschritte sind sogar auf einer Baustelle unter beengten Bedingungen durchführbar. Das Resultat ist eine flexibel anpassbare und nahezu vollständige Bedeckung der Gebäudehülle.

Diese Aufgaben und zusätzlich die Möglichkeit, auch exotisch geformte Dach- und Fassadenflächen mit Photovoltaikmodulen auszustatten, sind durch die hier vorgestellten Photovoltaikmodule und das Verfahren möglich.

### Kurze Beschreibung der Zeichnungen

Ein bevorzugtes Ausführungsbeispiel des Erfindungsgegenstandes wird nachstehend im Zusammenhang mit den anliegenden Zeichnungen beschrieben.
- Figur 1: zeigt eine perspektivische Darstellung eines Gebäudes, wobei die Dachfläche und die Fassadenfläche teilweise mit Photovoltaikmodulen bedeckt ist und ein Photovoltaikmodul in der Detailansicht.
- Figur 2a: zeigt eine perspektivische Ansicht eines Photovoltaikmoduls mit Blick auf die Frontseite, während
- Figuren 2b bis 2d: perspektivische Ansichten jeweils von der Rückseite von verschiedenen Photovoltaikmodulen zeigen.
- Figur 3: zeigt eine perspektivische Darstellung einer Fassadenfläche eines Gebäudes nach Montage zugeschnittener Photovoltaikmodule.

### Beschreibung

Photovoltaikmodule 1 bilden auf Dach- und/oder Fassadenflächen einen Teil einer Photovoltaikanlage, wobei hier im Wesentlichen Photovoltaikmodule 1 an sich, ohne Elektronik und Befestigung dargestellt sind.

Es werden starre plattenartig ausgeführte Photovoltaikmodule 1 verwendet, wobei jedes Photovoltaikmodul 1 eine verkapselte Laminatstruktur 12 gestapelter und miteinander unlösbar verbundener Lagen unterschiedlicher Funktion aufweist. Die Photovoltaikmodule 1 sind derart starr ausgeführt, dass sie selbsttragend sind und als Fassadenplatte und/oder Dachplatte zur Bedeckung von Fassadenflächen und/oder Dachflächen einsetzbar sind, wobei die Photovoltaikmodule 1 nur geringfügig verbiegbar sind.

An einer Seite sind elektrische Anschlüsse 10 vorgesehen, welche zur elektrischen Kontaktierung jedes Photovoltaikmoduls 1 benötigt werden. Die Laminatstruktur 12 umfasst eine Frontschutzscheibe 120, als Glasscheibe oder Kunststoffscheibe 120, ein Matrixmaterial 121, eine frontseitige Elektrodenlage 122, eine photovoltaische Lage 123, eine rückseitige Elektrodenlage 124 und eine Rückwand 125. Die hier aufgezeigten Lagen bilden keine abschliessende Aufzählung der in Photovoltaikmodulen 1 verwendbaren Lagen. Die frontseitige Elektrodenlage 122 ist in Form dünner Kontakte auf der dem Licht zugewandten Seite ausgestaltet, während die rückseitige Elektrodenlage 124 in Form eines flächigen Kontaktes auf der Rückseite der photovoltaische Lage 123 ausgestaltet ist. Die elektrischen Anschlüsse 10 können als Kabel oder Steckverbinder gestaltet sein, womit die elektrischen Anschlüsse 10 an einer Anschlussdose des Photovoltaikmoduls 1 kontaktiert werden.

Die Frontschutzscheibe 120 ist hier als ungehärtetes Glas ausgestaltet, was ausreichend mechanischen Schutz gegen Fremdeinwirkungen liefert. Die Lagen sind miteinander in einem dem Fachmann bekannten Herstellungsverfahren verkapselt laminiert und damit untrennbar. Die Frontschutzscheibe 120 kann aber auch von einem ausreichend robusten Kunststoff gebildet werden, welcher Strahlung im gewünschten Wellenlängenbereich ausreichend gut durchlässt, mechanisch ausreichend stabil ist und widerstandsfähig gegen Umwelteinflüsse ist. Auch diese Kunststoffscheibe bildet einen Teil der Laminatstruktur 12 und ist untrennbar mit ihr verbunden.

Die photovoltaische Lage 123 oder auch photoaktive Lage, kann wahlweise siliziumbasiert aus monokristallinem oder polykristallinem Silizium bestehen oder andere Materialien umfassen. Entscheidend ist, dass die Laminatstruktur 12, umfassend die photovoltaische Lage 123 verkapselt ist.

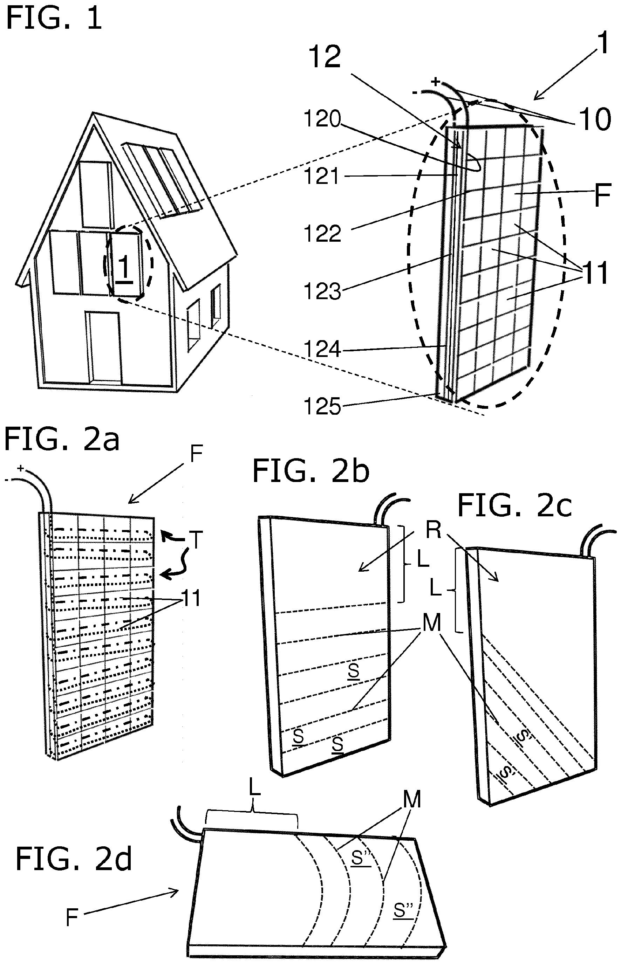

Auf der Frontseite F, welche von der Frontschutzscheibe 120 gebildet wird, sind in der Regel die einzelnen Solarzellen 11 erkennbar (ausser bei Dünnschichtzellen), welche das gesamte Photovoltaikmodul 1 bilden. In derartigen meist rechtwinkligen Gebilden sind die Photovoltaikmodule 1 kommerziell erhältlich. In Figur 2a ist die Frontseite F, die im Betrieb besonnte Seite, mit angedeuteter Verschaltung der einzelnen Solarzellen 11 gezeigt. Hier sind die Solarzellen 11 in Strängen T angeordnet, die in der Abbildung horizontal verlaufen, wobei Solarzellen 11 eines Stranges T in Reihe geschaltet sind. Von der letzten Solarzelle 11 eines Stranges T ist ein Kabel zum Minuspol gelegt. Es können auch Parallelschaltungen durchgeführt sein bzw. die Anordnung der Stränge T kann in vertikaler Richtung oder auch diagonal ausgeführt sein. Je nach Schaltungsart ist eine Anpassung von Markierungen M auf der Rückseite R nötig, wobei die Orientierung der Markierungen M mit der Orientierung der Stränge T zusammenhängt. Die Verschaltung der Solarzellen 11 ist heute auch auf mögliche Defekte oder Abschattungen optimiert. So sind in der Regel mehrere Bypass-Dioden vorgesehen, welche bei einem Defekt einer Solarzelle 11 bzw. einem Strang T, eine Überhitzung bzw. eine Stromentnahme aus dem Photovoltaikmodul 1 verhindern. Im besten Fall ist jede einzelne Solarzelle 11 jedes Stranges T durch eine Bypass-Diode abgesichert, sodass jede Solarzelle 11, welche verschattet oder defekt ist, überbrückt ist. Die Bypass-Dioden sind im besten Fall im Photovoltaikmodul 1 integriert. Es kann aber auch eine entsprechende Schaltung in der Anschlussdose ausserhalb des Photovoltaikmoduls 1 vorgesehen sein.

Die Figuren 2b bis 2d zeigen beispielhaft mögliche Markierungen M, welche beispielsweise auf der Rückseite R des Photovoltaikmoduls 1 in unterschiedlichen Orientierungen vor Lieferung zur Baustelle fixiert angeordnet sein können. Die Markierungen M sind in einem lateralen Abstand L von den elektrischen Anschlüssen 11 angeordnet, sodass auch nach einem Zuschnitt noch eine Mindesteffizienz des Photovoltaikmoduls 1 erreichbar ist. Da unterschiedlich grosse vorkonfektionierte Photovoltaikmodule 1 erhältlich sind, sind Schnitte und entsprechend Markierungen M nur auf einem Teil des Photovoltaikmoduls 1 sinnvoll. Im besten Fall ist die Kontaktierung der verschiedenen Stränge T der Solarzellen 11 auf die Markierungen M angepasst, somit bleiben nach einem Schnitt entlang der Markierungen M möglichst viele Solarzellen 11 aktiv.

Die Markierungen M sind auf der Rückseite R der Rückwand 125 auszuführen, wobei die Markierungen M gezeichnet oder lackiert werden. Auch Gravieren oder Anreissen ist möglich, wobei Stifte oder Reissnadeln verwendet werden, welche je nach Beschaffenheit der Rückwand 125 ausreichend gut sichtbare Markierungen M hinterlassen, ohne die Stabilität des Photovoltaikmoduls 1 zu schwächen.

Alternativ können die Markierungen M in Form von photovoltaisch inaktiven Bereichen, innerhalb der photovoltaischen Lage 123 verlaufend, ausgeführt sein. Diese photovoltaisch inaktiven Bereiche sind beim Blick auf die Frontseite F der Laminatstruktur 12 mit blossem Auge erkennbar und damit auf der Frontseite F angeordnet. Eine extra Zeichnung oder Markierung auf der Rückseite R ist dann nicht unbedingt notwendig. In einem photovoltaisch inaktivem Bereich kann die photovoltaische Lage 123 Lücken aufweisen, sodass in diesen Bereichen die photovoltaische Lage 123 teilweise fehlt. Entsprechend sind die abtrennbaren Schnittbereiche S durch Abschnitte fehlender photovoltaischer Lage 123 gebildet und die Ränder dieser photovoltaisch inaktiven Bereiche bilden die Markierungen M.

### Verfahren

Das erfindungsgemässe Verfahren kann direkt auf einer Baustelle durchgeführt werden, umfasst nur wenige Schritte und führt schnell und trotzdem zu präzisen gewünschten Ergebnissen. Beispielhaft wird das Verfahren mit einem starren plattenartig ausgeführten Photovoltaikmodul 1 mit der verkapselte Laminatstruktur 12, umfassend eine ungehärtete Glasscheibe als Frontschutzscheibe 120 im Folgenden beschrieben. Das Verfahren lässt sich entsprechend auch auf ein Photovoltaikmodul 1 mit Kunststoffscheibe als Frontschutzscheibe 120 übertragen bzw. an Kunststoff-Photovoltaikmodulen 1, dessen Laminatstrukturlagen auf Kunststoffen basieren, durchgeführt werden.

### Zuschnitt

Ein zuzuschneidendes Photovoltaikmodul 1 mit Frontschutzscheibe 120 aus ungehärtetem Glas wird auf der Baustelle mit einer Schneidvorrichtung zugeschnitten, indem im Bereich der Markierungen M entlang mindestens einer Markierung M ein Teilstück des Photovoltaikmoduls 1 abgeschnitten wird. Das Photovoltaikmodul 1 wird dazu bevorzugt auf seiner Frontseite F aufliegend gehalten, wodurch eine Delamination während des Zuschnittes verhindert werden kann.

Der Zuschnitt erfolgt lateral von den elektrischen Anschlüssen 10 beabstandet, sodass ein späterer elektrischer Anschluss, wie gewohnt möglich ist. Da die Verkabelung der einzelnen Solarzellen 11 mit Bypass-Dioden ausgestattet ist, bleiben unverletzte Solarzellen automatisch aktiv und können Strom liefern. Wird der Zuschnitt entlang der Markierungen M durchgeführt, ist die erreichbare Stromerzeugung maximiert.

Die Schneidvorrichtungen müssen kompakt, transportabel und vor Ort einfach zu bedienen sein, sodass der Zuschnitt direkt auf der Baustelle oder in einer Werkstatt möglich ist. Bevorzugt liegt das Photovoltaikmodul 1 plan horizontal auf einer Ablagefläche auf, während der Schneideprozess durchgeführt wird.

Als Schneidvorrichtung kann eine Fliesen- und/oder Glasschneidmaschine mit rotierender Diamantscheibe eingesetzt werden. Die Fliesen- und/oder Glasschneidmaschine kann von Hand über das liegende Photovoltaikmodul 1 entlang einer der Markierungen M, eine Schnittkante erzeugend geführt werden. In einer weiteren Ausführungsform kann die Fliesen- und/oder Glasschneidmaschine mit einem Untergestell zur Ablage des Photovoltaikmoduls 1 verbunden sein und einen Führungsrahmen umfassen, an welchem das Schneidmittel präzise entlang einer gewünschten Schnittlinie entlang führbar ist.

Die Schneidvorrichtung kann auch mittels Laserstrahl oder auch mittels Wasserstrahlverfahren wirtschaftlich betrieben werden.
Wenn die Markierungen M von photovoltaisch inaktiven Bereichen in der photovoltaischen Lage 123 der Laminatstruktur 12 gebildet werden, erfolgt der Zuschnitt von der Frontseite F. Die Markierungen M werden dann von den Grenzen der photovoltaisch inaktiven Bereiche gebildet.

Der Zuschnitt kann auch durch Brechen geritzter Photovoltaikmodule 1 durchgeführt werden. Dazu sind Markierungen M in Form vorgefertigter Ritze am Photovoltaikmodul 1 angebracht. Durch Brechen entlang dieser Sollbruchstellen kann das Photovoltaikmodul 1 auf die gewünschte Grösse angepasst werden.

### Entgraten

Nach dem Schnitt kann die Schnittkante entgratet bzw. die Schnittkante gebrochen werden, was mit einem Handentgratwerkzeug erfolgen kann, bevorzugt aber mit einer portablen Handschleifmaschine mit rotierend betriebener Schleifscheibe passiert. Auch ein Winkelschleifer mit rotierender Schleifscheibe kann verwendet werden. Die Schnittkanten können aber auch mit einem Schwingschleifer gebrochen werden.

Neben den Graten an den äusseren Lagen, Frontschutzscheibe 120 und Rückwand 125, können auch Grate der Zwischenlagen, des Matrixmaterials 121, der frontseitigen Elektrodenlage 122, der photovolatischen Lage 123 und/oder der rückseitigen Elektrodenlage 124 beseitigt werden.

Das zu benutzende Entgratungswerkzeug muss handgeführt sein, sodass es einfach auf einer Baustelle einsetzbar ist. Die jeweils zu verwendende Schleifscheibe bzw. das Schleifpapier müssen in ihrer Körnung auf die Lagen des Photovoltaikmoduls 1 angepasst sein und sind als Diamantschleifscheibe oder als Schruppscheibe ausgestaltet. Dabei muss darauf geachtet werden, dass keine Fremdkörper zwischen die Lagen der Laminatstruktur 12 gelangen.

### Versiegeln

Anschliessend kann die entgratete Schnittkante je nach verwendetem Photovoltaikmodul 1 versiegelt werden. Dies verhindert das Eindringen von Fremdkörpern, sowie von Feuchtigkeit und Gasen, sodass Oxidationsprozesse dauerhaft verhindert werden können.

Neben dampfdichten Dichtstoffen in Form von Acrylfugenmasse kann ein Aluminium-Klebeband zur Versiegelung benutzt werden. Die Schnittkante wird mit dem Dichtstoff im Bereich der Übergänge zwischen den einzelnen Lagen der Laminatstruktur 12 versiegelt, wobei der Übergang möglichst grossflächig mit dem Dichtstoff bedeckt wird. Beispielsweise mittels Kartuschenpistole ist der Dichtstoff kontrolliert auf die Schnittkante aufbringbar.

### Verklebung

Um die Delamination dauerhaft zu verhindern, kann eine Verklebung der entgrateten und versiegelten Schnittkante stattfinden. Dafür können beispielsweise starke einseitig klebende Klebebänder verwendet werden. Bevorzugt sollten Klebebänder mit Verstärkungsgewebe verwendet werden, wobei auf die Licht- bzw. UV-Beständigkeit geachtet werden muss. Auch wenn die Schnittkante der Sonnenstrahlung nicht direkt ausgesetzt ist, sollte ein Klebeband verwendet werden, welches der UV-Strahlung über einen längeren Zeitraum trotzen kann.

Nach dem Schnitt ist die Laminatstruktur 12 an der Schnittkante verletzt und es könnte zu einer Delamination kommen. Das geschnittene Photovoltaikmodul 1 sollte darum bis nach der Entgratung der Schnittkante und/oder der Versiegelung und/oder der Verklebung nicht bewegt werden.

Je nach verwendetem Photovoltaikmodul 1 sollte das Entgraten und/oder das Versiegeln und/oder das Verkleben der Laminatlagen an der Schnittkante erfolgen. Auch wenn die Laminatstruktur 12 verletzt wird ist es somit möglich die Photovoltaikmodule 1 vor Ort auf gewünschte Grössen anzupassen.

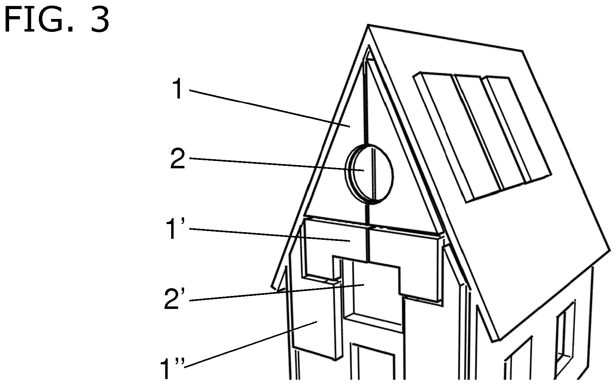

In Figur 3 ist beispielhaft eine Fassadenfläche mit einem Giebel gezeigt, wobei mehrfach zugeschnittene Photovoltaikmodule 1, 1', 1" verwendet werden. So können Phtotovoltaikmodule 1, 1', 1" neben Fenstern 2, 2' angeordnet werden, wobei die Photovoltaikmodule 1, 1', 1" aus unterschiedlich grossen kommerziell erhältlichen PV-Modulen 1, 1', 1" vor Ort hergestellt werden können. Die verbleibenden unverletzten Solarzellen 11 tragen hier jeweils zur Stromproduktion bei. Die Montage und Verkabelung der zugeschnittenen Photovoltaikmodule 1, 1', 1" erfolgt wie gewohnt, da auf die elektrischen Anschlüsse 10 geachtet worden ist. Zur Montage werden handelsübliche Befestigungskonstruktionen verwendet, an welchen die Photovoltaikmodule 1 dauerhaft befestigt werden.

Wenn das Photovoltaikmodul 1 eine aus Kunststoff gebildete Frontschutzscheibe 120 und Rückwand 125 aufweist, kann der Zuschnitt des Photovoltaikmoduls 1 noch einfacher erfolgen. Ein solches Photovoltaikmodul 1 kann durch Wärmeeinwirkung, beispielsweise mittels eines Glühdrahtes geschnitten werden. Bei diesem Schneideprozess verschmelzen die Lagen der Laminatstruktur 12 während des Zuschnittes, wobei eine Versiegelung und/oder ein Verkleben direkt nach dem Zuschnitt erfolgen. Es ist keine gesonderte Kantenbearbeitung mehr erforderlich, wenn derartige Photovoltaikmodule 1 verwendet werden.

### Bezugszeichenliste

1 Photovoltaikmodul / Solarmodul
   F Frontseite
   R Rückseite
      M Markierung
      S abtrennbarer Schnittbereich
      T Strang
      L lateraler Abstand
   10 el. Anschlüsse
   11 Solarzelle (in Reihe oder parallel zu Einzelsolarmodul geschaltet)
   12 Laminatstruktur
   120 Frontschutzscheibe
   121 Matrixmaterial
   122 frontseitige Elektrodenlage/dünne Kontakte auf Licht zugewandter Seite
   123 photovoltaische Lage/ photoaktive Schicht
   124 rückseitige Elektrodenlage/ Flächige Kontakte auf Rückseite
   125 Rückwand (Kunststoffe oder Glas)
2 Fenster

## Patentansprüche

1. Verfahren zur Schaffung von Photovoltaikanlagen mit mehreren starren Photovoltaikmodulen (1) in gewünschter Gestalt, wobei das Photovoltaikmodul (1)
eine verkapselte Laminatstruktur (12), umfassend eine Frontschutzscheibe (120), ein Matrixmaterial (121) von welchem eine frontseitige Elektrodenlage (122) und eine photovoltaische Lage (123) umschlossen ist, sowie eine rückseitige Elektrodenlage (124) und eine Rückwand (125) aufweist, mit elektrischen Anschlüssen (10) an einer Seite des Photovoltaikmoduls (1), wobei die photovoltaische Lage (123) durch mehrere Solarzellen (11) in mehreren Strängen (T) angeordnet gebildet ist, wobei die Solarzellen (11) jedes Stranges (T) durch mindestens eine Bypass-Diode abgesichert sind,
**gekennzeichnet durch,**
einen Zuschnitt mindestens eines der Photovoltaikmodule (1) abgestimmt auf mindestens eine am Photovoltaikmodul (1) fixierte Markierung (M), die einen abtrennbaren Schnittbereich (S) durch mögliche Schnittkanten auf dem Photovoltaikmodul (1) definiert, wobei der Zuschnitt lateral von den elektrischen Anschlüssen (10) beabstandet erfolgt, bevor ein Entgraten der Schnittkante der Laminatstruktur (12) und/oder
ein Versiegeln der Schnittkante zwischen benachbarten Lagen und/oder
ein Verkleben aller Lagen der Laminatstruktur (12) im Bereich der Schnittkante senkrecht zu den Lagenübergangsflächen erfolgt, wobei alle Verfahrensschritte direkt am Ort einer Baustelle oder Werkstatt durchgeführt werden, bevor die zugeschnittenen Photovoltaikmodule (1) auf einer Dach- und/oder Fassadenfläche als Teil der Baustelle montiert werden und anschliessend verkabelt werden.

2. Verfahren nach Anspruch 1, wobei die Markierung (M) bzw. der abtrennbare Schnittbereich (S) auf der Rückseite (R) des Photovoltaikmoduls (1) angeordnet ist, der Zuschnitt auf der Rückseite (R) erfolgt und das Photovoltaikmodul (1) während des Zuschnittes auf seiner Frontseite (F) aufliegt.

3. Verfahren nach einem der Ansprüche 1 oder 2, wobei das zugeschnittene Photovoltaikmodul (1) bis nach der Entgratung und/oder Versiegelung und/oder Verklebung der Schnittkante unbewegt am Ort der Baustelle gelagert gehalten wird.

4. Verfahren nach einem der vorhergehenden Ansprüche, wobei der Zuschnitt mit einer Fliesen- und/oder Glasschneidmaschine mit rotierender Diamantscheibe erfolgt.

5. Verfahren nach einem der vorhergenden Ansprüche, wobei das Entgraten mit einem Handentgratwerkzeug, bevorzugt mit einer portablen Handschleifmaschine mit rotierend betriebener Schleifscheibe, wie einem Winkelschleifer oder einem Schwingschleifer erfolgt.

6. Verfahren nach Anspruch 5, wobei für das Entgraten eine Diamantschleifscheibe oder eine Schruppscheibe verwendet werden.

7. Verfahren nach einem der Ansprüche 1 bis 6, wobei das Versiegeln mit einem dampfdichten Dichtstoff, beispielsweise einer Acrylfugenmasse oder einem Aluminium-Klebeband durchgeführt wird.

8. Verfahren nach Anspruch 7, wobei der dampfdichte Dichtstoff mittels Kartuschenpistole aufgebracht wird.

9. Verfahren nach einem der Ansprüche 1 bis 8, wobei das Verkleben der Schnittkante mit einem Klebeband, bevorzugt einem mit einem Gewebe verstärkten Klebeband erfolgt.

10. Starres Photovoltaikmodul (1) mit einer verkapselten Laminatstruktur (12), umfassend eine Frontschutzscheibe (120), ein Matrixmaterial (121) von welchem eine frontseitige Elektrodenlage (122) und eine photovoltaische Lage (123) umschlossen ist, sowie eine rückseitige Elektrodenlage (124) und eine Rückwand (125), wobei das Photovoltaikmodul (1) an einer Seite elektrische Anschlüsse (10) aufweist, wobei mehrere Solarzellen (11) in mehreren Strängen (T) angeordnet gebildet sind,
wobei die Solarzellen (11) jedes Stranges (T) durch mindestens eine Bypass-Diode abgesichert sind, wodurch das Photovoltaikmodul (1) bei teilweisem Zuschnitt automatisch aktiv bleibt, **dadurch gekennzeichnet, dass** auf der Rückseite (R) der Rückwand (125) des Photovoltaikmoduls (1) oder auf der Frontseite in der photovoltaischen Lage (123) in Form von Lücken in der photovoltaischen Lage (123) eine Mehrzahl von Markierungen (M), von den elektrischen Anschlüssen (11) lateral beabstandet angebracht sind, welche abtrennbare Schnittbereiche (S) bzw. mögliche Schnittkanten kennzeichnen, da die Orientierung der Markierungen (M) auf die Orientierung der Stränge (T) der Solarzellen (11) abgestimmt ist, wodurch das starre Photovoltaikmodul (1) und damit die verkapselte Laminatstruktur (12) entlang der Markierungen (M) zuschneidbar ist.

11. Photovoltaikmodul (1) nach Anspruch 10, wobei die Markierungen (M) auf der Rückseite (R) gezeichnet, lackiert oder eingraviert sind.

## Claims

1. Method for creating photovoltaic modules with a plurality of rigid photovoltaic modules (1) in the desired shape, wherein the photovoltaic module (1) has
an encapsulated laminate structure (12) comprising a front protective screen (120), a matrix material (121) which encloses a frontal electrode layer (122) and a photovoltaic layer (123), and a rearside electrode layer (124) and a rear wall (125), with electrical connections (10) on one side of the photovoltaic module (1), wherein the photovoltaic layer (123) is formed by a plurality of solar cells (11) in a plurality of strands (T), the solar cells (11) of each strand (T) being protected by at least one bypass diode,
**characterized by**
cutting at least one of the photovoltaic modules (1) to a size matched to at least one marker (M) fixed to the photovoltaic module (1), which defines a safely separable cutting area (S) on the photovoltaic module (1), wherein the cut is made a lateral distance away from the electrical connections (10), before
deburring the cut edge of the laminate structure (12) and/or
sealing the cut edge between adjacent layers and/or
bonding all layers of the laminate structure (12) in the area of the cut edge perpendicular to the layer transition surfaces, wherein all method steps are carried out directly on the construction site before the cut photovoltaic modules (1) are mounted on a roof and/or facade surface and then wired.

2. Method according to Claim 1, wherein the marker (M) or the separable cutting area (S) is arranged on the rear (R) of the photovoltaic module (1), the cut is made on the rear side (R) and the photovoltaic module (1) is placed on its front side (F) during the cutting.

3. Method according to either of Claims 1 or 2, wherein the cut photovoltaic module (1) is stored in the same position at the construction site or workshop until after the deburring and/or sealing and/or bonding of the cutting edge.

4. Method according to any one of the preceding claims, wherein the cutting is carried out with a tile- and/or glass-cutting machine with a rotating diamond disc.

5. Method according to any one of the preceding claims, wherein the deburring is carried out with a manual deburring tool, preferably with a portable manual grinding machine with a rotary grinding disc, such as an angle grinder or oscillating sander.

6. Method according to Claim 5, wherein a diamond grinding disc or a roughing disc is used for the deburring.

7. Method according to any one of Claims 1 to 6, wherein the sealing is carried out with a vapourtight sealant, for example an acrylic mastic or an aluminium adhesive tape.

8. Method according to Claim 7, wherein the vapourtight sealant is applied using a cartridge gun.

9. Method according to any one of Claims 1 to 8, wherein the cut edge is bonded using an adhesive tape, preferably a fabric-reinforced adhesive tape.

10. Rigid photovoltaic module (1) having an encapsulated laminate structure (12) comprising a front protective screen (120), a matrix material (121) which encloses a frontal electrode layer (122) and a photovoltaic layer (123), and a rearside electrode layer (124) and a rear wall (125), the photovoltaic module (1) having electrical connections (10) on one side, with a plurality of solar cells (11) being arranged in a plurality of strands (T),
wherein the solar cells (11) of each strand (T) are protected by at least one bypass diode, with the result that the photovoltaic module (1) automatically remains active when partially cut to size and a plurality of markers (M), laterally spaced apart from the electrical connections (11), are applied on the rear side (R) of the rear wall (125) of the photovoltaic module (1) or on the front side in the photovoltaic layer (123) in the form of gaps in the photovoltaic layer (123), which identify separable cutting areas (S) or possible cutting edges, since the orientation of the markers (M) is matched to the orientation of the strands (T) of the solar cells (11), which enables the rigid photovoltaic module (1) and thus the encapsulated laminate structure (12) to be cut to size along the markers (M).

11. Photovoltaic module (1) according to Claim 10, wherein the markers (M) on the rear side (R) are drawn, painted, or engraved.

## Revendications

1. Procédé de création de systèmes photovoltaïques avec une pluralité de modules photovoltaïques rigides (1) dans la forme souhaitée, dans lequel le module photovoltaïque (1) présente une structure stratifiée encapsulée (12) comprenant un écran de protection avant (120), un matériau matriciel (121) par lequel une couche d'électrode avant (122) et une couche de panneau photovoltaïque (123) sont entourées, ainsi qu'une couche d'électrode arrière (124) et une paroi arrière (125), avec des connexions électriques (10) sur un côté du module photovoltaïque (1), dans lequel la couche photovoltaïque (123) est formée de plusieurs cellules solaires (11) agencées en plusieurs chaînes (T), dans lequel les cellules solaires (11) de chaque chaîne (T) sont protégées par au moins une diode de dérivation,
**caractérisé par**
une découpe d'au moins un des modules photovoltaïques (1) de manière correspondante à au moins un marquage (M) fixé sur le module photovoltaïque (1), qui définit une zone de coupe séparable (S) à travers d'éventuels bords de coupe sur le module photovoltaïque (1), dans lequel la découpe a lieu de manière espacée latéralement des connexions électriques (10), avant qu'un ébavurage du bord de coupe de la structure stratifiée (12) et/ou
un scellement du bord de coupe entre des couches adjacentes et/ou
un collage de toutes les couches de la structure stratifiée (12) dans la zone du bord de coupe ait lieu perpendiculairement aux zones de transition de couche, dans lequel toutes les étapes du processus sont effectuées directement sur le site d'un chantier de construction ou d'un atelier avant que les modules photovoltaïques découpés (1) ne soient installés sur un toit et/ou une surface de façade dans le cadre du chantier de construction puis câblés.

2. Procédé selon la revendication 1, dans lequel le marquage (M) ou la zone de découpe séparable (S) est disposé sur la face arrière (R) du module photovoltaïque (1), la découpe est réalisée sur la face arrière (R) et le module photovoltaïque (1) repose sur sa face avant (F) lors de la découpe.

3. Procédé selon une quelconque des revendications 1 ou 2, dans lequel le module photovoltaïque découpé (1) est maintenu immobile sur le site du chantier jusqu'à l'ébavurage et/ou le scellement et/ou le collage du bord de coupe.

4. Procédé selon une quelconque des revendications précédentes, dans lequel la découpe a lieu avec une machine de découpe de carreaux et/ou de verre à disque diamant rotatif.

5. Procédé selon une quelconque des revendications précédentes, dans lequel l'ébavurage est effectué avec un outil d'ébavurage manuel, de préférence avec une meuleuse à main portable comportant une meule rotative, telle qu'une meuleuse d'angle ou une ponceuse vibrante.

6. Procédé selon la revendication 5, dans lequel une meule à disque diamant ou une meule à ébarber est utilisée.

7. Procédé selon une quelconque des revendications 1 à 6, dans lequel le scellement est réalisé avec un mastic étanche à la vapeur, par exemple un composé à joint acrylique ou un ruban adhésif en aluminium.

8. Procédé selon la revendication 7, dans lequel le produit d'étanchéité étanche à la vapeur est appliqué au moyen d'un pistolet à cartouche.

9. Procédé selon une quelconque des revendications 1 à 8, dans lequel le collage du bord de coupe est effectué avec un ruban adhésif, de préférence un ruban adhésif renforcé par un tissu.

10. Module photovoltaïque rigide (1) avec une structure stratifiée encapsulée (12), comprenant un écran de protection avant (120), un matériau matriciel (121) par lequel une couche d'électrode avant (122) et une couche photovoltaïque (123) sont entourées, ainsi qu'une couche d'électrode arrière (124) et une paroi arrière (125), dans lequel le module photovoltaïque (1) présente des connexions électriques (10) sur un côté, dans lequel plusieurs cellules solaires (11) sont agencées en plusieurs chaînes (T),
dans lequel les cellules solaires (11) de chaque chaîne (T) sont protégées par au moins une diode de dérivation, moyennant quoi le module photovoltaïque (1) reste automatiquement actif lorsqu'il est partiellement coupé, **caractérisé en ce que** sur la face arrière (R) de la paroi arrière (125) du module photovoltaïque (1) ou sur la face avant dans la couche photovoltaïque (123) sous la forme d'espaces vides dans la couche photovoltaïque (123) une pluralité de marquages (M) sont ménagés, espacés latéralement des connexions électriques (11), qui définissent des zones de coupe séparables (S) ou d'éventuels bords de coupe, car l'orientation des marquages (M) est adaptée à l'orientation des chaînes (T) des cellules solaires (11), moyennant quoi le module photovoltaïque rigide (1) et ainsi la structure stratifiée encapsulée (12) peuvent être découpés le long des marquages (M).

11. Module photovoltaïque (1) selon la revendication 10, dans lequel les marquages (M) sur la face arrière (R) sont dessinés, peints ou gravés.
